# EUROPÄISCHE PATENTANMELDUNG

(11) **EP 0 677 827 A2**
(43) Veröffentlichungstag der Anmeldung: **18.10.1995**
(21) Anmeldenummer: 95105154.9
(22) Anmeldetag: 06.04.1995
(51) Int. Cl.: G07B 13/02

(54) **Montageoptimierte Anordnung der Funktionselemente eines Taxameters**

(30) Priorität: 16.04.1994 DE 9406371 U
(71) Anmelder: VDO Adolf Schindling AG, D-60326 Frankfurt/Main (DE)
(72) Erfinder: Schmid, Mechtilde, Dipl.-Ing. (FH), D-78052 Villingen-Schwenningen (DE); Jäckle, Holger, Dipl.-Ing. (FH), D-78087 Mönchweiler (DE)

(57) **Zusammenfassung**

Es wird eine Architektur für einen Taxameter vorgeschlagen, die eine optimale Montage gestattet.

Im einzelnen werden an einem frontseitigen Gehäusebauteil (5) des zweiteiligen Gehäuses des Taxameters, an welchem geeignete Aufnahme- und Ausrichtmittel ausgebildet sind, durch Einlegen oder Aufstecken wenigstens eine Glasscheibe (2), eine Flüssigkristallanzeige (4) und ein Lichtleiter (31) lose gehaltert und durch Befestigen einer Leiterplatte (36) an dem frontseitigen Gehäusebauteil (5) mittelbar mit diesem fest verbunden.

## Beschreibung

Die Erfindung betrifft eine montageoptimierte Anordnung der Funktionselemente eines Taxameters mit im wesentlichen einem zweiteiligen Gehäuse, einer den elektronischen Rechner und die Datenspeicher der Taxameters tragenden Leiterplatte, einer Flüssigkristallanzeige, einem der Flüssigkristallanzeige rückseitig zugeordneten Lichtleiter, einer Glascheibe sowie Steuertasten.

Taxameter werden in Mietfahrzeugen eingesetzt und dienen bekanntlich der Berechnung des Fahrpreises und dessen Darstellung derart, daß der Mietpreis für Fahrer und Kunde zweifelsfrei lesbar ist. Bei der Berechnung des Fahrpreises werden Werte einer örtlichen Tarifordnung mit Strecken und Zeiteinheiten multipliziert und aufsummiert. Da Taxameter vielfach in vom Fahrzeughersteller vorgesehene Nieschen und Ausnehmungen im Armaturenbrett des betreffenden Fahrzeuges eingebaut werden müssen, sind die Maße des Gerätes in einer Weise vorgegeben, daß bei einer bezogen auf die Frontfläche des Gerätes möglichst formatfüllenden Anzeige eine konsequente Nutzung des zur Verfügung stehenden Geräteraumes erforderlich ist. Außerdem erwartet der Erwerber eines Taxameters, daß auch ein Taxameter dem im Kraftfahrzeugsektor üblichen Kostenrahmen für Fahrzeuginstrumente angepaßt ist, so daß für die Fertigung von Taxametern auch die Bedingungen der Großserie zu beachten sind. Das heißt, es ist die geringstmögliche Bauteileanzahl, möglichst einfache Bauteile sowie eine einfache und weitgehend mechanisierbare Montierbarkeit bei einer relativ geringen Anzahl von Montageschritten anzustreben.

Der Erfindung lag somit die Aufgabe zugrunde, einen Taxameter zu schaffen, dessen Architektur sich in optimaler Weise für die Großserienherstellung eignet, so daß der Taxameter mit einem Minimum an Fertigungsaufwand herstellbar ist.

Die Lösung der gestellten Aufgabe beschreibt der Anspruch 1. Weitere vorteilhafte Ausgestaltungen der Erfindung gehen aus den Unteransprüchen hervor.

Der fertigungstechnische Vorteil der gefundenen Lösung ist insbesondere darin zu sehen, daß sie eine besonders einfache Montage gestattet. Dabei ist die Leiterplatte in einem weitgehend fertig montierten Zustand des Gerätes noch zugänglich und somit das Gerät prüffähig, das heißt, es ist lediglich noch das rückseitige Gehäusebauteil an der mit dem frontseitigen Gehäusebauteil gebildeten funktionsfertigen Baueinheit des Taxameters zu befestigen. Die Bildung der funktionsfertigen Baueinheit und somit die weitgehende Fertigstellung des Gerätes erfolgt durch Einlegen und Aufstecken der Funktionselemente in einer Richtung und letztlich durch Verrasten der Leiterplatte mit dem frontseitigen Gehäusebauteil vorzugsweise in Verbindung mit der Verwendung zweier Schrauben.

Im einzelnen werden folgende Montageschritte zur Schaffung der genannten Baueinheit vorgenommen:
Das frontseitige Gehäusebauteil, mit anderen Worten der frontseitige Gehäuserahmen, wird vorgelegt,
die mit Anschlagleisten versehene Glasscheibe wird in den Ausschnitt des frontseitigen Gehäusebauteils eingelegt,
die Flüssigkristallanzeige wird unmittelbar auf die Glasscheibe aufgelegt, wobei im frontseitigen Gehäusebauteil Ausrichtmittel ausgebildet sind, die die Lage der Flüssigkristallanzeige bestimmen,
der Lichtleiter wird auf Ansätze, die an an dem frontseitigen Gehäusebauteil angeformten Gewindebolzen ausgebildet sind, aufgesteckt,
die durch das frontseitige Gehäusebauteil hindurchgreifenden, vorzugsweise an einer Schaltmatte, angeformten Steuertasten sowie die die elektronische Verbindung zwischen der Leiterplatte und der Flüssigkristallanzeige schaffenden Verbinder werden eingelegt,
die Leiterplatte wird auf weitere, am frontseitigen Gehäusebauteil angeformte, mit Durchgangsöffnungen versehene Ansatzbolzen, aufgesteckt,
die Leiterplatte, die auf den Stirnseiten der Gewindebolzen aufliegt, wird mit den Gewindebolzen verschraubt.

Im folgenden sei die Erfindung anhand der beigefügten Zeichnungen näher erläutert. Es zeigen:
Fig. 1 eine Frontansicht eines Erfindungsgemäß gebauten Taxameters,
Fig. 2 eine Rückansicht des frontseitigen Gehäusebauteils,
Fig. 3 eine Explosionsdarstellung der Gehäusebauteile und der Funktionselemente des Taxameters,
Fig. 4 einen Schnitt gemäß der Schnittlinie A in Fig. 1.

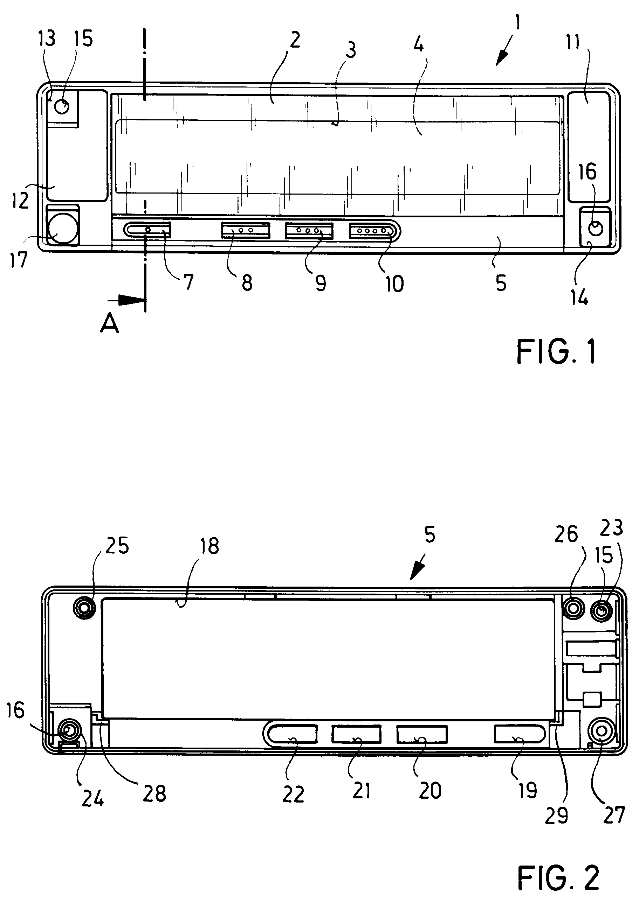

Die Fig. 1 zeigt die an sich übliche Frontseite eines Taxameters 1 mit einer Glasscheibe 2, die als Schriftblatt dient und an der ein durchsichtiger Bereich 3 für die Beobachtung der Anzeigemittel des Taxameters 1, vorzugsweise einer Flüssigkristallanzeige 4, ausgeblendet ist. Der Taxameter 1, dessen Gehäuse aus einem rahmenförmigen frontseitigen Gehäusebauteil 5 und einem schalenförmigen rückseitigen Gehäusebauteil 6 besteht, weist ferner die üblichen mit 7, 8, 9 und 10 bezeichneten Steuertasten auf und ist mit einem Typenschild 11 versehen. Mit 12 ist eine Abdeckung für ein sogenanntes Servicefach bezeichnet, in welchem ein Steckersockel für einen Parametrier - und Diagnosestecker sowie eine Pufferbatterie zugänglich sind. Die Bezugszeichen 13 und 14 bezeichnen Vertiefungen, in die bei der Montage des Taxameters 1 am Einbauort den Befestigungsschrauben zugeordnete Plombennäpfchen einsetzbar sind. Mit 15 und 16 sind Bohrungen bezeichnet, die dem Durchführen der Befestigungsschrauben dienen. Mit einer Plombe 17 ist eine die Gehäusebauteile 5 und 6 verbindende Schraube gesichert.

Wie aus der Rückansicht des Gehäusebauteils 5, Fig 2, ersichtlich ist, ist ein relativ großer Ausschnitt 18 für das Einsetzen der Glasscheibe 2 vorgesehen. Mit 19, 20, 21 und 22 sind den Steuertasten 7, 8, 9 und 10 zugeordnete Öffnungen vorgesehen. Die Bohrungen, die in Fig. 1 mit 15 und 16 bezeichnet sind, befinden sich in Ansatzbolzen 23 und 24. Ferner sind an dem frontseitigen Gehäusebauteil 5 zwei Gewindebolzen 25 und 26 angeformt, die ebenfalls mit Ansätzen versehen sind. Mit 27 ist ein Pfosten bezeichnet, welcher als Distanzpfosten beim Verschrauben des frontseitigen Gehäusebauteils 5 mit dem rückseitigen Gehäusebauteil 6 dient. Eine für diesen Zweck, durch den Pfosten 27 durchgeführte nicht dargestellte Schraube, ist, wie bereits erwähnt, mit der Plombe 17 gesichert. Als Ausrichtmittel, insbesondere für die Flüssigkristallanzeige 4, dienen außerdem zwei angeformte Winkelstücke 28 und 29.

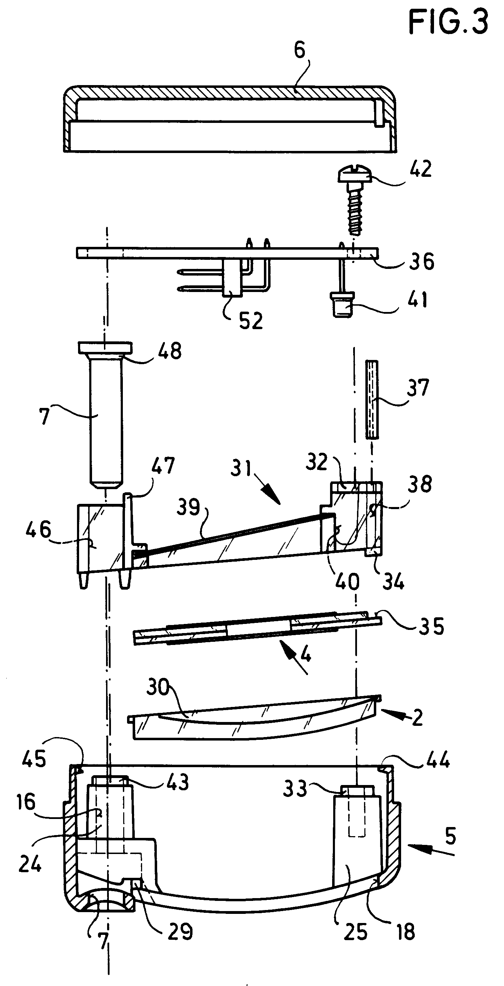

Aus der Explosionsdarstellung, Fig. 3, ist ersichtlich, daS das frontseitige Gehäusebauteil 5 das tragende Bauteil des Taxameters 1 darstellt, an welchem die übrigen Funktionselemente während der Montage ausgerichtet und lose gehaltert und letztlich befestigt werden. Dabei erfolgt die Montage einer funktionsfertigen Baueinheit, die lediglich noch durch Anbringen des rückseitigen Gehäusebauteils 6 zu vervollständigen ist, ausschließlich in einer Richtung. Im Gegensatz zum vorliegenden Ausführungsbeispiel, bei dem das Verbinden der Gehäusebauteile 5 und 6 mittels einer frontseitig gesetzten Schraube erfolgt, ist das Zusammenfügen selbstverständlich auch von der Rückseite her möglich.

Bei der Montage wird zunächst die Glasscheibe 2, an der randlich wenigstens teilweise, und zwar den Konturen des Gehäusebauteils 5 entsprechende Anschlagleisten angeformt sind, in den Ausschnitt 18 eingelegt. Für die nachfolgend unmittelbar auf die Glasscheibe 2 aufzulegende Flüssigkristallanzeige 4 dienen, wie bereits erwähnt, die Winkelstücke 28 und 29 als Fassung. Zusätzlich wird die Flüssigkristallanzeige 4 durch einen Lichtleiter 31 gehalten. An dem Lichtleiter 31 sind Ösen 32 angeformt, deren Stärke der Höhe der an den Gewindebolzen 25, 26 ausgebildeten Ansätze 33 entsprechen. Mit 34 sind wenigstens zwei am Lichtleiter 31 ausgebildete Finger bezeichnet, die in die gestuft ausgebildete eine Stirnseite der Flüssigkristallanzeige 4 teilweise eingreifen. An der mit 35 bezeichneten Fläche der an der Flüssigkristallanzeige 4 ausgebildeten Stufe sind Kontakte zur Ansteuerung der einzelnen Zeichenelemente der Flüssigkristallanzeige 4 aufgebracht. Die elektrische Verbindung dieser Kontakte mit auf einer Leiterplatte 36 befindlichen Kontakten erfolgt mittels eines oder mehrerer aus elastischem Material hergestellten, bandförmigen Verbindern 37, zu deren Halterung im Lichtleiter 31 geeignete Schlitze 38 ausgebildet sind.

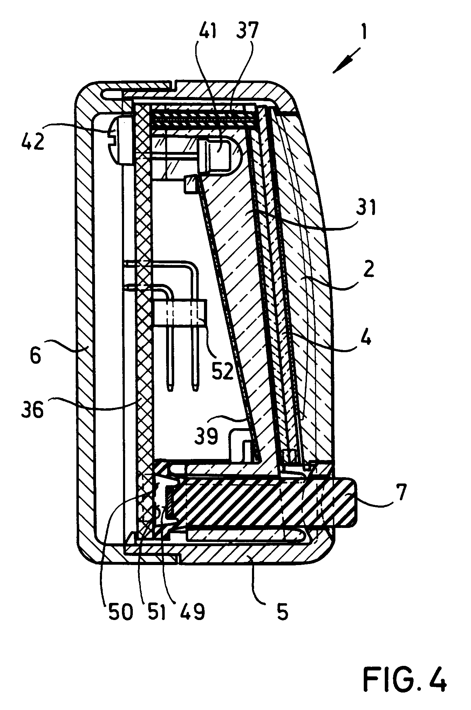

Mit 39 ist ein mit dem Lichtleiter 31 verbundener, das heißt, in nicht näher bezeichneten Schlitzen gehalterter Reflektor bezeichnet. Ferner ist in dem Lichtleiter 31 eine Reihe von Sackbohrungen 40 mit vorzugsweise kugelig ausgeformtem Bohrungsgrund ausgebildet. In diese Sackbohrungen 40 tauchen auf der Leiterplatte 36 befestigte Leuchtdioden 41 ein, wenn die Leiterplatte 36 mit dem Gehäusebauteil 5 verbunden wird, mit anderen Worten, wenn die auf den Stirnflächen der Gewindebolzen 25, 26 aufliegende Leiterplatte 36 mittels vorzugsweise selbstsschneidender Schrauben, von denen in den Fig. 3 und 4 eine dargestellt und mit 42 bezeichnet ist, an dem frontseitigen Gehäusebauteil 5 festgeschraubt wird. Die Ausrichtung der Leiterplatte 36 erfolgt durch Aufstecken auf die an den Ansatzbolzen 23 und 24 angeformten Ansätze, von denen in Fig. 3 einer mit 43 bezeichnet ist. Einer Fixierung der Leiterplatte 36 vor dem Festschrauben dienen an dem Gehäusebauteil 5 angeformte Rastnasen 44 und 45.

Bevor die Leiterplatte 36 aufgesetzt und festgeschraubt werden kann, sind die Steuertasten 7, 8, 9 und 10 zu montieren. Diese werden in an dem Lichtleiter 31 entsprechend der Querschnittsform der Tastenschäfte ausgebildete Öffnungen 46 eingesetzt. Mit anderen Worten, die Öffnungen 46 entsprechen querschnittsmäßig den Öffnungen 19, 20, 21 und 22 und dienen den Tastenschäften als Führungen. Vorzugsweise sind die Steuertasten als Schaltmatte beziehungsweise als Schaltmattenstreifen ausgebildet, der durch geeignete, an dem Lichtleiter 31 angeformte Stege 47, auf der Leiterplatte 36, niedergehalten wird, wenn diese mit dem Gehäusebauteil 5 verschraubt ist. Bei einer derartigen Schaltmatte erfolgt der Schnappeffekt, das heißt, die Rückstellung einer Steuertaste nach deren Betätigung durch einen membranartigen elastischen Kragen, der mit 48 bezeichnet ist.

Wie aus der Fig. 4 ersichtlich ist, sind die Steuertasten 7, 8, 9 und 10 jeweils mit einer elektrisch leitenden Scheibe 49 versehen, mittels welcher bei Betätigung einer Steuertaste auf der Leiterplatte 36 angeordnete Kontakte 50, 51 überbrückbar sind. Stellvertretend für eine Vielzahl auf der Leiterplatte 36 angeordneter elektronischer Bauteile ist in den Fig. 3 und 4 ein Steckersockel dargestellt und mit 52 bezeichnet. Im übrigen macht die Fig. 4 deutlich, daß bei der durch den neuerungsgemäßen Aufbau erzielten Gerätetiefe von weniger als 30 mm die unterschiedlich hohen elektronsichen Bauteile nur bei einer konsequenten Raumnutzung innerhalb der relativ flachen Räume beiderseits der Leiterplatte 36 untergebracht werden können.

Der Vollständigkeit halber sei noch erwähnt, daß indem am Lichtleiter 31 Rastmittel ausgebildet werden, die die Leiterplatte 36 umgreifen oder in diese eingreifen, eine aus Leiterplatte, Lichtleiter und zwischenliegender Schaltmatte bestehende vormontierbare Baueinheit gebildet werden kann. Denkbar ist ferner, daß die Glasscheibe 2 unmittelbar an dem Lichtleiter 31 angeformt und ein Schlitz vorgesehen sein kann, in welchem die Flüssigkristallanzeige 4 zusammen mit einem Schriftblatt einschiebbar ist.

## Patentansprüche

1. Montageoptimierte Anordnung der Funktionselemente eines Taxameters mit im wesentlichen einem zweiteiligen Gehäuse einer den elktronischen Rechner- und die Datenspeicher des Taxameters tragenden Leiterplatte, einer Flüssigkristallanzeige, einem der Flüssigkristallanzeige rückseitig zugeordneten Lichtleiter, einer Glasscheibe sowie Steuertasten,
dadurch gekennzeichnet,
daß vorzugsweise an dem frontseitigen Gehäusebauteil (5) Aufnahme- und Ausrichtmittel ausgebildet sind, die während der Montage des Taxameters (1) durch Einlegen oder Aufstecken eine lose Halterung von wenigstens der Glasscheibe (2), der Flüssigkristallanzeige (4) und des Lichtleiters (31) an dem frontseitigen Gehäusebauteil (5) ermöglichen und
daß die Befestigung der Funktionselemente (2, 4, 31, 36) mittelbar durch Befestigen der Leiterplatte (36) an dem frontseitigen Gehäusebauteil (5) erfolgt.

2. Montageoptimierte Anordnung nach Anspruch 1,
dadurch gekennzeichnet,
daß das rückseitige Gehäusebauteil (6) an der durch die Leiterplatte (36), die Steuertasten (7, 8, 9, 10), den Lichtleiter (31), die Flüssigkristallanzeige (4), die Glasscheibe (2) und das frontseitige Gehäusebauteil (5) gebildeten funktionsfertigen Baueinheit des Taxameters (1) mittels wenigstens einer durch die Baueinheit durchgeführten und frontseitig plombierbaren Schraube befestigt ist.

3. Montageoptimierte Anordnung nach Anspruch 1,
dadurch gekennzeichnet,
daß die Steuertasten (7, 8, 9, 10) an einer Schaltmatte angeformt sind und
daß die Schaltmatte nach dem Befestigen der Leiterplatte (36) an dem frontseitigen Gehäusebauteil (5) auf der Leiterplatte (36) durch geeignete, an einem der miteinander verbundenen Funktionselemente ausgebildete Konturen (Stege 47) festgespannt ist.

4. Montageoptimierte Anordnung nach Anspruch 1,
dadurch gekennzeichnet,
daß in dem Lichtleiter (31) Fassungen für zwischen der Flüssigkristallanzeige (4) und der Leiterplatte (36) vorgesehene elastische, elektrische Verbinder (37) ausgebildet sind.

5. Montageoptimierte Anordnung nach Anspruch 3,
dadurch gekennzeichnet,
daß an dem Lichtleiter (31) Führungen für die Steuertasten (7, 8, 9, 10) ausgebildet sind.

6. Montageoptimierte Anordnung nach Anspruch 1,
dadurch gekennzeichnet,
daß an dem frontseitigen Gehäusebauteil (5) mit Ansätzen (33) versehene Gewindebolzen (25, 26) als Ausrichtmittel für den Lichtleiter (31) und mit Ansätzen (43) versehene Ansatzbolzen (23, 24) als Ausrichtmittel für die Leiterplatte (36) derart ausgebildet sind, daß eine auf den Ansätzen (43) der Ansatzbolzen (23, 24) aufgenommene Leiterplatte (36) auf den Gewindebolzen (25, 26) stirnseitig aufliegt und mit diesen verschraubbar ist.
